# EUROPEAN PATENT SPECIFICATION

(11) **EP 2 599 244 B1**
(45) Date of publication and mention of the grant of the patent: **23.03.2016**
(21) Application number: 10737334.2
(22) Date of filing: 30.07.2010
(51) Int. Cl.: H04B 10/50, H01S 5/022, H01S 5/026, H01S 5/14, H04B 10/572, H01S 5/40

(54) **OPTICAL NETWORK ELEMENT, PROCESS OF MANUFACTURE AND METHOD FOR GENERATING LIGHT BEAMS**
OPTISCHES NETZWERKELEMENT, HERSTELLUNGSVERFAHREN UND VERFAHREN ZUR ERZEUGUNG VON LICHTSTRAHLEN
ÉLÉMENT DE RÉSEAU OPTIQUE, PROCÉDÉ DE FABRICATION ET PROCÉDÉ POUR GÉNÉRER DES FAISCEAUX DE LUMIÈRE

(43) Date of publication of application: 05.06.2013
(73) Proprietor: Xieon Networks S.à r.l., 2633 Senningerberg (LU)
(72) Inventor: ROHDE, Harald, 81673 München (DE)
(74) Representative: Lucke, Andreas
(86) International application number: PCT/EP2010/061122
(87) International publication number: WO 2012/013244

(56) References cited:
- WO-A1-02/43202
- US-A- 5 216 680
- US-B1- 6 289 032
- US-B1- 6 538 817
- US-B1- 6 876 679
- RONEN E ET AL: "Passive phase locking of 169 lasers", LASERS AND ELECTRO-OPTICS, 2009 AND 2009 CONFERENCE ON QUANTUM ELECTRONICS AND LASER SCIENCE CONFERENCE. CLEO/QELS 2009. CONFERENCE ON, IEEE, PISCATAWAY, NJ, USA, 2 June 2009 (2009-06-02), pages 1-2, XP031520978, ISBN: 978-1-55752-869-8

## Description

The invention relates to an optical network element, a process of manufacture and a method for generating light beams.

A passive optical network (PON) is a promising approach regarding fiber-to-the-home (FTTH), fiber-to-the-business (FTTB) and fiber-to-the-curb (FTTC) scenarios, in particular as it overcomes the economic limitations of traditional point-to-point solutions.

Several PON types have been standardized and are currently being deployed by network service providers worldwide. Conventional PONs distribute downstream traffic from the optical line terminal (OLT) to optical network units (ONUs) in a broadcast manner while the ONUs send upstream data packets multiplexed in time to the OLT. Hence, communication among the ONUs needs to be conveyed through the OLT involving electronic processing such as buffering and/or scheduling, which results in latency and degrades the throughput of the network.

In fiber-optic communications, wavelength-division multiplexing (WDM) is a technology which multiplexes multiple optical carrier signals on a single optical fiber by using different wavelengths (colors) of laser light to carry different signals. This allows for a multiplication in capacity, in addition to enabling bidirectional communications over one strand of fiber.

WDM systems are divided into different wavelength patterns, conventional or coarse and dense WDM. WDM systems provide, e.g., up to 16 channels in the 3rd transmission window (C-band) of silica fibers of around 1550 nm. Dense WDM uses the same transmission window but with denser channel spacing. Channel plans vary, but a typical system may use 40 channels at 100 GHz spacing or 80 channels at 50 GHz spacing. Some technologies are capable of 25 GHz spacing. Amplification options enable the extension of the usable wavelengths to the L-band, more or less doubling these numbers.

Optical access networks, e.g., coherent Ultra-Dense Wavelength Division Multiplex (UDWDM) networks, could be used as a future data access.

Data transmission of spectrally densely spaced wavelengths is utilized by applications such as Next Generation Optical Access (NGOA) systems allowing high data rates of, e.g., 100 Gbit/s.

In these optical scenarios, a multitude of optical wavelengths is required in order to be individually modulated. Such optical wavelengths may have a spectral distance of a few gigahertz and can be used either for an ultra dense wavelength grid optical access system like NGOA where each user may be assigned a wavelength of his own or for a transmission of high data rates a multitude of wavelengths are bundled and transmitted over a small spectral range.

A prior art system is known from WO/02/43202.

It is, however, a disadvantage that several discrete laser sources providing such wavelengths may interfere with each other or are not at a constant frequency distance from each other (e.g., due to temperature effects). This situation becomes even more critical in case the laser sources are closely spaced to each other (e.g., separated by a frequency range amounting to 3 GHz).

The **problem** to be solved is to improve an existing optical system and in particular to efficiently provide optical wavelengths at a spectral distance of, e.g., a few GHz and at the same time allow for a precise adjustment of such optical wavelengths.

This problem is solved according to the features of the independent claims. Further embodiments result from the depending claims.

In order to overcome this problem, an optical network element is provided
- comprising several lasers, wherein dielectric filter is arranged within at least one resonator of the lasers,
- wherein for each laser, light in the resonator enters the dielectric filter at a predetermined angle,
- wherein the light generated within each laser enters the dielectric filter at a different angle.

The optical network element may be any system, device or optical component or a portion thereof. The optical network element may be a substrate with an arrangement as suggested.

Advantageously, this concept allows that the laser (or any comparable light source) provides light beams at different wavelengths, wherein the wavelengths are separated by, e.g., a few gigahertz. The spectral distance between the light beams is substantially unsusceptible against temperature variation, because any change of temperature applies to the whole arrangement, e.g., the photonic motherboard on which the several lasers and/or the dielectric filter are deployed.

It is noted that several dielectric filters could be provided, wherein each dielectric filter is entered by light of a resonator or cavity of at least one laser. Each dielectric filter may thus be a frequency (or wavelength) defining element for several lasers.

The approach presented can be used as a device to provide several light beams of different frequencies. Hence, for example, long haul DWDM laser arrays can be provided in an efficient manner.

In an embodiment, the angles for the several lasers (substantially) differ by a predetermined angle or a multiple thereof.

Hence, each of the several lasers has a resonator and a gain medium, wherein light generated by the gain medium enters the dielectric filter at a different angle compared to the angle that is applied to the resonator of the other lasers.

It is in particular noted that a single laser may not utilize the dielectric filter and thus provides a light beam without any deviation or impact by such dielectric filter.

The predetermined angle can be regarded as an offset angle resulting in an offset frequency (wavelength). Thus, the lasers via the coupling with the dielectric filter provide light beams that are spectrally separated from each other by a frequency that is determined by the different angles.

In a further embodiment, the dielectric filter is arranged within a cavity of the lasers.

The cavity of the laser can also be regarded as resonator comprising a gain medium and is in particular arranged between a mirror and a semi-transparent mirror.

In a next embodiment, each laser comprises
- a gain medium, wherein one side of the gain medium is connected to a semi-transparent mirror, and
- a waveguide that is connected to the other side of the gain medium and to a mirror via the dielectric filter.

Thus, each laser via its gain medium and the angle at which its light enters the dielectric filter provides an outgoing light beam of a given frequency.

The gain medium of the laser generates light that is fed via the dielectric filter to the mirror and reflected back to the gain medium. The light generated leaves the laser via the semi-transparent mirror.

The laser gain media may be realized as semiconductor optical amplifiers (SOAs).

It is also an embodiment that the light of the gain medium is conveyed to the dielectric filter by a waveguide.

Pursuant to another embodiment, said waveguide is an etched waveguide within a layer.

According to an embodiment, said layer can be a layer on a motherboard, in particular a photonic motherboard.

According to another embodiment, the mirror and/or the semi-transparent mirror is/are arranged in an etched or milled slot of the motherboard.

In yet another embodiment, the mirror is used for several lasers.

A single mirror can be used for several waveguides, i.e. the light passing the dielectric filter can be conveyed via several waveguides to this mirror and back via the dielectric filter to the gain media. This may be applicable for several lasers in parallel.

According to a next embodiment, the dielectric filter is used for several lasers.

Hence, the light from the gain medium can be fed to the dielectric filter via the waveguide and enter the dielectric filter at a predefined angle, wherein a single dielectric filter can be used for being connected via several waveguides to several gain media.

Pursuant to yet an embodiment, the dielectric filter is movable or rotatable.

By moving or rotating, the angle at which light enters the dielectric filter can be adjusted. Thus, the frequency of the light beam supplied by the laser(s) can be adjusted.

The problem stated above is also solved by a process of manufacture of the optical network element as described herein, wherein the dielectric filter is applied using a hybrid photonic integration technology.

According to an embodiment, the dielectric filter is realized by coating a substrate with alternating films of material of at least partially different refraction indices.

The problem mentioned above is also solved by a method for generating several light beams by several lasers,
- wherein for each laser light is conveyed via a dielectric filter within the resonator of this laser,
- wherein said light enters the dielectric filter at a predetermined angle,
- wherein the light generated within each laser enters the dielectric filter at a different angle.

Hence, the light beam's frequency generated by each laser depends on the angle at which the light enters the dielectric filter. Each laser may provide a light beam of different frequency, because the light within the respective laser's resonator enters the dielectric filter at a different angle.

It is noted that one or several dielectric filters could be provided for said several lasers.

The remaining aspects disclosed herein apply to the method in an according manner.

Also, the problem stated above is solved by a communication system comprising in particular at least one of said optical network elements.

Embodiments of the invention are shown and illustrated in the following figure:

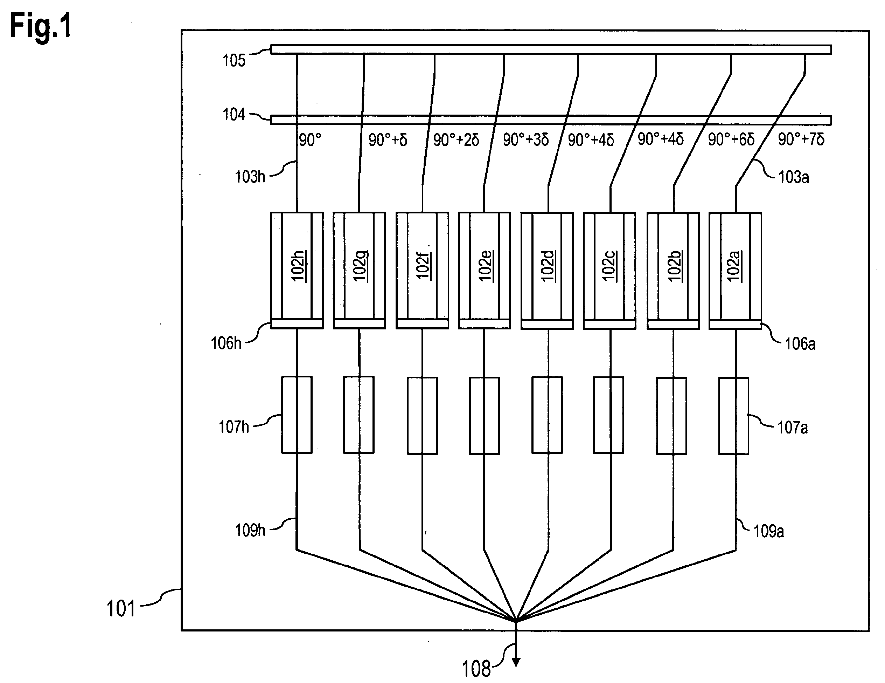

- Fig.1: shows a schematic diagram of a photonic motherboard comprising an array of laser gain media, wherein waveguides are etched on the motherboard and a dielectric filter is arranged in an etched or precision milled slot of the motherboard.

The solution provided herein in particular suggests using a multitude of lasers (also referred to as laser sources or light sources) to provide spectrally separated light beams. Advantageously, the approach works well even in case the light beams are separated only by a small frequency band, e.g., 3 GHz. It is another advantage that the spectral distance between the different (adjacent) light beams can be maintained without any additional active locking mechanism to be provided.

Hence, it is suggested using a small band dielectric filter as a frequency selective element provided in the laser cavity. The transmission window (which is identical to the laser's wavelength in case the dielectric filter is arranged within a laser resonator) depends on an angle at which the light beam enters and/or passes the filter. Hence, the transmission wavelength (and therefore the laser wavelength) can be adjusted if the dielectric filter is moved or rotated.

A single dielectric filter can be provided as a frequency defining element for several lasers. Light generated at each laser impinges on the dielectric filter at a different angle. In particular, the angle at which a particular light beam enters the dielectric filter is (slightly) different from the angle(s) at which its adjacent laser(s) enter(s) the dielectric filter.

A photonic motherboard or layer can be used for conveying the light beams. A cavity in the photonic motherboard may comprise a waveguide structure, wherein light is conveyed via separate waveguides, and wherein each waveguide intersects with the dielectric filter at a different angle.

**Fig.1** shows a schematic diagram of a photonic motherboard 101 (e.g., a silicon motherboard) comprising an array of laser gain media 102a to 102h, which may be realized each as a semiconductor optical amplifier (SOA). Waveguides 103a to 103h are etched on the motherboard 101. A dielectric filter 104 is arranged in an etched or precision milled slot of the motherboard 101. Also, a mirror 105 is located in an etched or precision milled slot of the motherboard 101.

The gain medium 102a generates light that is fed by the waveguide 103a via the dielectric filter 104 to the mirror 105 and back to the gain medium 102a. The amplified light passes a semi-transparent mirror 106a as a light beam and is fed by a waveguide 109a to a modulator 107a, where an electrical signal can be used for modulating data onto the optical signal. The modulated light beam is then conveyed via said waveguide 109a to a single output fiber 108. This applies accordingly for the other laser arrangements accordingly, wherein the light generated by each of the laser's gain medium enters the dielectric filter 104 at a different angle. The modulated light beams of the lasers are combined onto said optical fiber 108. The modulators 107a to 107h can be arranged as a modulator array.

The waveguides 103a to 103h pass the dielectric filter 104 each at a slightly different angle. An angle offset δ corresponds to a frequency offset Δv. Hence, the configuration shown in Fig.1 is arranged for generating light beams at the frequencies v₀, v₀+Δv, v₀+2Δv, ..., v₀+7Δv.

It is an advantage of this solution that in case of a temperature change, such change applies to all lasers of the motherboard 101 and to the dielectric filter, thus maintaining the spectral distances between the respective light beams. Hence, adjacent light beams maintain their spectral distance even in case of a temperature change without the requirement of providing additional locking mechanisms.

It is also an advantage that the solution can be implemented by using hybrid photonic integration technologies. The frequency selective dielectric filter can be realized by coating a substrate with alternating films of material with different refraction indices. Such a dielectric filter can be produced of a 2 or 3 inch wafer and many hundreds can be cut out of a single waver.

### List of Abbreviations:

- DWDM: Dense WDM
- FTTB: Fiber-to-the-Business
- FTTC: Fiber-to-the-Curb
- FTTH: Fiber-to-the-Home
- NGOA: Next Generation Optical Access
- OLT: Optical Line Terminal
- ONU: Optical Network Unit
- PON: Passive Optical Network
- SOA: Semiconductor Optical Amplifier
- UDWDM: Ultra Dense WDM
- WDM: Wavelength Division Multiplexing

## Claims

1. An optical network element
- comprising several lasers, wherein dielectric filter (104) is arranged within resonator of the lasers,
- wherein for each laser, light in the resonator is adapted to enter the dielectric filter (104) at a predetermined angle,
- wherein the light generated within each laser is adapted to enter the dielectric filter (104) at a different angle.

2. The optical network element according to claim 1, wherein the angles for the several lasers differ by a predetermined angle or a multiple thereof.

3. The optical network element according to any of the preceding claims, wherein the dielectric filter (104) is arranged within a cavity of the lasers.

4. The optical network element according to any of the preceding claims, wherein each laser comprises
- a gain medium (102), wherein one side of the gain medium is connected to a semi-transparent mirror (106), and
- a waveguide (103) that is connected to the other side of the gain medium (102) and to a mirror (105) via the dielectric filter (104).

5. The optical network element according to claim 4, wherein the light of the gain medium (102) is conveyed to the dielectric filter (104) by a waveguide (103).

6. The optical network element according to claim 5, wherein said waveguide (103) is an etched waveguide within a layer.

7. The optical network element according to claim 6, wherein said layer can be a layer on a motherboard (101), in particular a photonic motherboard.

8. The optical network element according to claim 7, wherein the mirror (105) and/or the semi-transparent mirror (106) is/are arranged in an etched or milled slot of the motherboard (101).

9. The optical network element according to any of claims 4 to 8, wherein the mirror (105) is used for several lasers (102).

10. The optical network element according to any of the preceding claims, wherein the dielectric filter (104) is used for several lasers (102).

11. The optical network element according to any of the preceding claims, wherein the dielectric filter (104) is movable or rotatable.

12. A process of manufacture of the optical network element according to any of the preceding claims, wherein the dielectric filter (104) is applied using a hybrid photonic integration technology.

13. The process of manufacture according to claim 12, wherein the dielectric filter (104) is realized by coating a substrate with alternating films of material of at least partially different refraction indices.

14. A method for generating several light beams by several lasers,
- wherein for each laser light is conveyed via a dielectric filter (104) within the resonator of this laser,
- wherein said light enters the dielectric filter (104) at a predetermined angle,
- wherein the light generated within each laser enters the dielectric filter (104) at a different angle.

## Patentansprüche

1. Optisches Netzwerkelement
- umfassend mehrere Laser, wobei ein dielektrischer Filter (104) innerhalb eines Resonators der Laser angeordnet ist,
- wobei Licht in dem Resonator für jeden Laser so angepasst wird, dass es unter einem vorbestimmten Winkel in den dielektrischen Filter eintritt,
- wobei das in einem jeden Laser erzeugte Licht so angepasst wird, dass es unter einem anderen Winkel in den dielektrischen Filter (104) eintritt.

2. Optisches Netzwerkelement nach Anspruch 1, wobei die Winkel für verschiedene Laser sich um einen vorbestimmten Winkel oder um ein Vielfaches davon unterscheiden.

3. Optisches Netzwerkelement gemäß einem der vorhergehenden Ansprüche, wobei der dielektrische Filter (104) innerhalb eines Hohlraums der Laser angeordnet ist.

4. Optisches Netzwerkelement gemäß einem der vorhergehenden Ansprüche, wobei jeder Laser
- ein Verstärkungsmedium (102) umfasst, wobei eine Seite des Verstärkungsmediums mit einem halbtransparenten Spiegel (106) verbunden ist, und
- einen Wellenleiter (103), der mit der anderen Seite des Verstärkungsmediums (102) und mittels des dielektrischen Filters (104) mit einem Spiegel (105) verbunden ist.

5. Optisches Netzwerkelement nach Anspruch 4, wobei das Licht des Verstärkungsmediums (102) von einem Wellenleiter (103) zu dem dielektrischen Filter (104) übermittelt wird.

6. Optisches Netzwerkelement nach Anspruch 5, wobei der besagte Wellenleiter (103) ein innerhalb einer Schicht geätzter Wellenleiter ist.

7. Optisches Netzwerkelement nach Anspruch 6, wobei die besagte Schicht eine Schicht auf einer Mutterplatine (101), insbesondere einer photonischen Mutterplatine, sein kann.

8. Optisches Netzwerkelement nach Anspruch 7, wobei der Spiegel (105) und/oder der halbtransparente Spiegel (106) in einem geätzten oder gefrästen Schlitz der Mutterplatine (101) angeordnet ist/sind.

9. Optisches Netzwerkelement gemäß einem der Ansprüche 4 bis 8, wobei der Spiegel (105) für mehrere Laser (102) benutzt wird.

10. Optisches Netzwerkelement gemäß einem der vorhergehenden Ansprüche, wobei der dielektrische Filter (104) für mehrere Laser (102) benutzt wird.

11. Optisches Netzwerkelement gemäß einem der vorhergehenden Ansprüche, wobei der dielektrische Filter (104) beweglich oder drehbar ist.

12. Verfahren zur Herstellung des optischen Netzwerkelements gemäß einem der vorangehenden Ansprüche, wobei der dielektrische Filter (104) mittels einer hybriden Photonenintegrationstechnologie ausgebildet wird.

13. Verfahren nach Anspruch 12, wobei der dielektrische Filter (104) realisiert wird, indem ein Substrat mit abwechselnden Schichten von Materialien beschichtet wird, die zumindest teilweise unterschiedliche Brechungsindices haben.

14. Verfahren zur Erzeugung von Lichtstrahlen von mehreren Laser,
- wobei Licht für jeden Laser über einen dielektrischen Filter (104) innerhalb des Resonators dieses Lasers übermittelt wird,
- wobei das besagte Licht unter einem vorbestimmten Winkel in den dielektrischen Filter (104) eintritt,
- wobei das in einem jeden Laser erzeugte Licht unter einem anderen Winkel in den dielektrischen Filter (104) eintritt.

## Revendications

1. Élément de réseau optique
comprenant plusieurs lasers, dans lequel
un filtre diélectrique (104) est disposé dans un résonateur des lasers,
dans lequel, pour chaque laser, la lumière dans le résonateur est conçue pour entrer dans le filtre diélectrique (104) suivant un angle prédéterminé,
dans lequel la lumière générée à l'intérieur de chaque laser est conçue pour entrer dans le filtre diélectrique (104) suivant un angle différent.

2. Élément de réseau optique selon la revendication 1, dans lequel les angles pour les différents lasers diffèrent d'un angle prédéterminé ou d'un multiple de celui-ci.

3. Élément de réseau optique selon l'une quelconque des revendications précédentes, dans lequel le filtre diélectrique (104) est disposé dans une cavité des lasers.

4. Élément de réseau optique selon l'une quelconque des revendications précédentes, dans lequel chaque laser comprend
un milieu de gain (102), dans lequel un côté du milieu de gain est connecté à un miroir semi-transparent (106), et
un guide d'ondes (103) qui est connecté à l'autre côté du milieu de gain (102) et à un miroir (105) par l'intermédiaire du filtre diélectrique (104).

5. Élément de réseau optique selon la revendication 4, dans lequel la lumière du milieu de gain (102) est transmise au filtre diélectrique (104) par un guide d'ondes (103).

6. Élément de réseau optique selon la revendication 5, dans lequel ledit guide d'ondes (103) est un guide d'ondes gravé à l'intérieur d'une couche.

7. Élément de réseau optique selon la revendication 6, dans lequel ladite couche peut être une couche sur une carte mère (101), en particulier une carte mère photonique.

8. Élément de réseau optique selon la revendication 7, dans lequel le miroir (105) et/ou le miroir semi-transparent (106) est/sont disposé(s) dans une fente gravée ou usinée de la carte mère (101).

9. Élément de réseau optique selon l'une quelconque des revendications 4 à 8, dans lequel le miroir (105) est utilisé pour plusieurs lasers (102).

10. Élément de réseau optique selon l'une quelconque des revendications précédentes, dans lequel le filtre diélectrique (104) est utilisé pour plusieurs lasers (102).

11. Élément de réseau optique selon l'une quelconque des revendications précédentes, dans lequel le filtre diélectrique (104) est mobile ou rotatif.

12. Procédé de fabrication de l'élément de réseau optique selon l'une quelconque des revendications précédentes, dans lequel le filtre diélectrique (104) est appliqué au moyen d'une technologie d'intégration photonique hybride.

13. Procédé de fabrication selon la revendication 12, dans lequel le filtre diélectrique (104) est réalisé en revêtant un substrat avec une alternance de films de matériau ayant des indices de réfraction au moins partiellement différents.

14. Procédé pour générer plusieurs faisceaux de lumière par plusieurs lasers,
dans lequel, pour chaque laser, la lumière est transmise par l'intermédiaire d'un filtre diélectrique (104) à intérieur du résonateur de ce laser,
dans lequel ladite lumière entre dans le filtre diélectrique (104) suivant un angle prédéterminé,
dans lequel la lumière générée à l'intérieur de chaque laser entre dans le filtre diélectrique (104) suivant un angle différent.
